# EUROPÄISCHE PATENTSCHRIFT

(11) **EP 1 084 600 B1**
(45) Veröffentlichungstag und Bekanntmachung des Hinweises auf die Patenterteilung: **28.04.2004**
(21) Anmeldenummer: 99932665.5
(22) Anmeldetag: 07.05.1999
(51) Int. Cl.: H05K 13/00

(54) **ANLAGE ZUM BESTÜCKEN VON BAUELEMENTETRÄGERN MIT ELEKTRISCHEN BAUELEMENTEN**
FACILITY FOR FITTING COMPONENT CARRIERS WITH ELECTRIC COMPONENTS
INSTALLATION POUR EQUIPER DES SUPPORTS DE COMPOSANTS AVEC DES COMPOSANTS ELECTRIQUES

(30) Priorität: 11.05.1998 DE 19821033
(43) Veröffentlichungstag der Anmeldung: 21.03.2001
(73) Patentinhaber: SIEMENS AKTIENGESELLSCHAFT, 80333 München (DE)
(72) Erfinder: ROHM, Rainer, D-81477 München (DE); MISON, Peter, 349277 Singapur (SG)
(86) Internationale Anmeldenummer: PCT/DE1999/001394
(87) Internationale Veröffentlichungsnummer: WO 1999/059389

(56) Entgegenhaltungen:
- DE-A- 3 601 699
- DE-A- 19 521 729
- US-A- 4 783 904
- US-A- 5 372 239

## Beschreibung

Die Erfindung bezieht sich auf ein Anlage zum Bestücken von Bauelementeträgern mit elektrischen Bauelementen, wobei die Anlage eine Transportstrecke und zumindest zwei Bestückplätze für die Bauelementeträger aufweist.

Es ist allgemein üblich, mehrere Bestückautomaten mit je einem Bestückplatz mittels einer geradlinig verlaufenden Transportstrecke zu verketten. Dadurch ist es möglich, ein großes Spektrum unterschiedlicher Bauelemente bereitzuhalten, die auf die verschiedenen Bestückautomaten verteilt sind. Dadurch können zum einen, Baugruppen, die eine große Vielfalt unterschiedlicher Bauelemente benötigen vollständig bestückt werden, ohne daß dazu Zuführmodule für die Bauelemente ausgewechselt werden müssen. Für schmale Bauelemente träger kann der Bestückautomat entsprechend zwei nebeneinanderliegende schmale Bestückplätzen aufweisen, auf denen abwechselnd kontinuierlich bestückt wird.

Zum anderen ist es aber auch möglich, eine Vielzahl unterschiedlicher Baugruppen von geringer Lösgröße mit geringem Umrüstaufwand zu bestücken. Dabei kann es allerdings vorkommen, daß Baugruppen mit einer geringen Anzahl von Bauelementen nur einen oder wenige Automaten durchlaufen müssen, um komplett bestückt werden zu können. Da auch diese Baugruppen die nicht benötigten Bestückplätze in annähernder Taktung durchlaufen, kann deren Kapazität nicht in vollem Umfange genutzt werden.

Bei den üblichen Bestückautomaten überdecken sich die Transportstrecke und die Bestückplätze. Es ist üblich, bei einem Bestückautomaten die Transportstrecke aus drei voneinander entkoppelten Teiltransporten zu bilden. Der Bestückplatz deckt sich weitgehend mit dem mittleren Teiltransport, der während des Bestückens gestoppt wird, während z.B. der vorangehende Teiltransport die nächste Leiterplatte heranführt. Um die zu bestückende Leiterplatte im Bestückbereich zu zentrieren ist nur eine einfache lineare Vorschubbewegung erforderlich.

Es ist in der Montagetechnik allgemein üblich, Transportstrecken an den Arbeitsplätzen vorbeizuführen und an diesen Stellen die zu bearbeitenden Werkstücke aus und wieder einzuschleusen, um die Werkstücke wahlfrei den Arbeitsplätzen zuführen zu können; wodurch sich jedoch der Zeitaufwand für die Wechselvorgänge erhöht.

Eine derartige Anlage ist beispielsweise ist durch die JP 4 176528 A bekannt geworden, wonach Bauelementeträger mittels in einer Linie hiritereinanderliegender Bestückautomaten mit elektrischen Bauelementen bestückt werden. Die Linie ist in mehrere Teilabschnitte mit je einer Bestückstrecke und zumindest einer Bypass- Förderstrecke unterteilt, die seitlich an dem Bestückäutomaten vorbeigeführt ist. Innerhalb der einzelnen Bestückstrecken werden identische Arbeitsschritte ausgeführt. Zwischen den Teilabschnitten sind quer verschiebbare Ubergabeeinrichtungen angeordnet, die die Bauelementeträger zwischen den Transportstrecken und Bestückstrecken verschieben. Den einzelnen Transportbändern sind Detektoren zugeordnet, die den Transport der Bauelementeträger so steuern, daß diese in jeweils eine freie Bestückstrecke eingeschleust werden. Dadurch ist es selbst beim temporären Ausfall eines Bestückautomaten möglich, die Anlage kontinuierlich weiter zu betreiben.

Der Erfindung liegt die Aufgabe zugrunde, in einer Anlage mit in Reihe angeordneten Bestückeinheiten bei hoher Bestückleistung Baugruppen mit stark unterschiedlichen Bestückinhalten herstellen zu können.

Diese Aufgabe wird durch die Erfindung gemäß Anspruch 1 gelöst. Durch die steuerbare Umschaltung zwischen den beiden Verkettungsweisen ist es möglich, die Bestückeinheiten ohne umzurüsten wahlweise in Reihe oder parallel zu betreiben. Beispielsweise können Leiterplatten für eine geringe Anzahl von Bauelementen unabhängig von einander an beliebigen Stelle von der Förderstrecke auf die Transportstrecke umgesetzt und nach Durchlaufen des Bestückplatzes wieder an die Förderstrecke zurückgegeben werden. Dadurch ist es möglich, daß mehrere solcher Baugruppen parallel nebeneinander ohne Kapazitätsverlust zu bestücken.

Baugruppenträger für eine hohe Vielzahl von Bauelementen können wie bisher mit geringen Wechselzeiten und hoher Taktrate von Bestückplatz zu Bestückplatz verfahren und deren Bauteilevorrat nutzen.

Es ist möglich, den Teilabschnitten jeweils einen der Bestückplätze zuzuordnen, so daß eine optimale Anpassung an unterschiedliche Bestückaufgaben möglich ist.

Es ist ferner möglich, die Übergabeeinrichtungen z.B. vor bzw. nach jedem zweiten Bestückplatz anzuordnen, wodurch sich der mechanische Aufwand, aber auch die Flexibilität verringert. Eine solche Anordnung ist insbesondere bei Bestückautomaten angezeigt, die zwei unmittelbar hintereinander liegende Bestückplätze aufweisen.

Durch die senkrechte Zuordnung der Strecken können die waagerecht liegenden Bauelementeträger durch eine senkrechte Verschiebung gewechselt werden. Die Breite der Montagelinie wird entsprechend geringer. Für schmale Bauelementeträger können wie bisher zwei eng benachbarte Transportstrecken sowie zwei entsprechend angeordnete Förderstrecken vorgesehen sein. Die Förderstrecke kann bei einer großhubig gestalteten Übergabeeinrichtung oberhalb oder unterhalb des Bestückautomaten verlaufen.

vorteilhafte Weiterbildungen der Erfindung sind in den Unteransprüchen gekennzeichnet:

Die Weiterbildung nach Anspruch 2 ermöglicht eine raumsparende Anordnung der Förderstrecken. Insbesondere hat sie den Vorteil, dab die Förderstrecken von den Bestückautomaten weitgehend entkoppelt angeordnet und betrieben werden können. Dadurch können die Bestückautomaten ohne Änderung ihrer Bauweise wahlfrei sowohl für den einspurigen als auch mehrsprurigen Betrieb verwendet werden.

Durch die Weiterbildung nach Anspruch 3 ist es möglich, den Bestückplatz an der Oberseite des Bestückautomaten gut einsehbar und zugänglich anzuordnen.

Durch die Weiterbildung nach Anspruch 4 wird die Übergabeeinrichtung mit dem Teiltransport zu einer Einheit zusammengefaßt die ein schnelles und genaues Umsetzen der Baugruppenträger ermöglicht.

Die Übergabeeinrichtung nach Anspruch 5 macht es möglich, die beiden Teiltransporte gleichzeitig in beide Strecken einzufügen und diese mit Ausnahme der Wechselvorgänge gleichzeitig und unabhängig voneinander zu betreiben.

Die Anordnung der Förderstrecke entlang der Unterseite der Bestückautomaten nach Anspruch 6 erfordert zwar einen großen Verschiebehub, ermöglicht es jedoch, die Bestückautomaten zu unverändert zu verwenden, die nur für einen Einspurbetrieb eingerichtet sind. Durch die Unabhängigkeit der Verschiebeantriebe ist es möglich, die entstehenden Lücken in den Strecken kurzfristig wieder zu schließen.

Die Teiltransporte nach Anspruch 7 erfordern einen geringeren Führungs- und Antriebsaufwand und eignen sich insbesondere für Anlagen mit einem geringen Abstand zwischen den beiden Strecken.

Durch die Weiterbildung nach Anspruch 8 können die Übergabeeinrichtungen in den Bestückautomaten integriert werden, so daß die aus mehreren Automaten bestehenden Linien durch einfaches Aneinanderreihen der Bestückautomaten gebildet werden können.

Die Bestückautomaten nach Anspruch 9 können an jeder beliebigen Stelle der Linie, insbesondere aber auch an deren Anfang und Ende eingesetzt werden.

Durch die Übergabeeinrichtung nach Anspruch 10 ist es möglich, auch eine außerhalb, insbesondere unterhalb der Bestückautomaten verlaufende Förderstrecke zu erreichen.

Die Anordnung nach Anspruch 11 ermöglicht eine weitere Entflechtung des Transportsystems mit einer entsprechenden Vereinfachung der Steuerungsmittel, wodurch z.B. auf optische Abtasteinrichtungen im Bereich der Übergabeeinrichtung zur Unterscheidung von unvollständig bzw. vollständig bestückten Bauelementeträgern verzichtet werden kann. Dabei ist es von Vorteil, wenn die Übergabeeinrichtung zwei unabhängig verschiebbare Teiltransporte für beide Parallelstrecken aufweist.

Die Anlage nach Anspruch 12 ermöglicht es, den Bauelementeträger aus der Transportstrecke heraus zu führen, ohne seine relative Lage zum jeweiligen Teiltransport zu verändern. In dieser Zeit wird die entstandene Lücke durch den anderen Teiltransport für weitere Transportvorgänge geschlossen, wobei der Träger nach Anspruch 13 den konstruktiven Aufwand verringert.

Die Förderstrecke nach Anspruch 14 ermöglicht ebenfalls raumsparend den zweispurigen Betrieb, ohne daß dafür die Bestückautomaten verändert werden müssen, was sich insbesondere mit Hilfe der Fußteile nach Anspruch 15 realisieren läßt.

Die Anordnung nach Anspruch 16 erfordert eine entsprechende konstruktive Abänderung des bisher einspurigen Bestückautomaten. In dessen Chassis muß ein Einbauraum für die Förderstrecke konzipiert werden, die in relativ engem Abstand unter der Transportstrecke angeordnet werden kann, so daß der Verschiebeweg und die Wechselzeiten erheblich verkürzt werden. Ein derartiger Bestückautomat kann dann je nach Kundenwunsch mit oder ohne eine zusätzliche Förderstrecke geliefert werden. Außerdem ist es ohne Schwierigigkeiten möglich, einen bereits ausgelieferten Bestückautomaten bei Bedarf mit der Förderstrecke nachzurüsten.

Im Folgenden wird die Erfindung anhand von in der Zeichnung dargestellten Ausführungsbeispielen näher erläutert. Es zeigen schematisiert:
- Figur 1: eine schematische Darstellung einer Anlage zum Bestücken von Bauelementeträgern mit elektrischen Bauelementen,
- Figur 2: die Anlage nach Figur 1 in einer anderen Einstellung,
- Figur 3: eine Seitenansicht einer weiteren Anlage zum Bestücken von Bauelementeträgern,
- Figur 4: eine weitere Seitenansicht einer anderen Anlage.

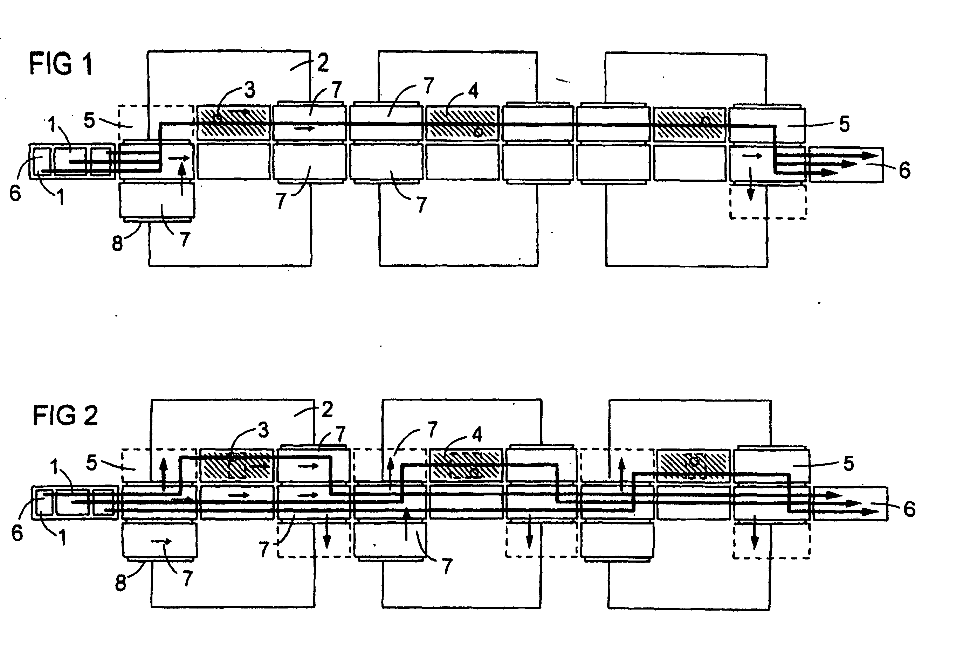

Nach Figur 1 weist eine Anlage zum Bestücken von Bauelementeträgern 1 drei in einer Reihe hintereinander stehende Bestückautomaten 2 auf, bei denen ein Bestückkopf über einem Bestückplatz 4 verfahrbar ist, an den die Bauelementeträger 1 transportierbar sind. Die Anlage weist zwei zueinander parallele, benachbarte separate Strecken zum Transport der Bauelementeträger 1 auf, wobei die an sich übereinanderliegenden Strecken aus Gründen der Übersichtlichkeit nebeneinander liegend dargestellt sind. Eine der Strecken ist als Transportstrecke 5 ausgebildet, die über die in einer Linie hintereinander liegenden Bestückplätze 4 führt. Die andere Strecke ist eine reine Förderstrecke 6, die an den Bestückplätzen 4 vorbeigeführt ist.

Die beiden Strecken sind in mehrere unabhängig voneinander betreibbare Abschnitte unterteilt, wobei die vor und nach dem Bestückplatz liegenden Abschnitte als in der Bestückebene quer zur Transportrichtung verschiebbare Teiltransporte 7 ausgebildet sind. Von diesen sind jeweils zwei einander benachbarte Teiltransporte 7 der Transportstrecke 5 und der Förderstrecke 6 auf einem gemeinsamen Träger 8 befestigt, der quer zur Transportrichtung um den Abstand der beiden Strecken verschiebbar ist und eine Übergabeeinrichtung bildet. Dadurch ist es möglich, den jeweiligen der Transportstrecke zugeordneten Teiltransport fluchtend in die Förderstrecke einzufügen, wie dies am linken Ende der Förderstrecke 6 dargestellt ist.

Ein in dem vorhergehenden Abschnitt bereit stehender Bauelementeträger kann nun durch Antreiben dieser beiden Abschnitte auf den Teiltransport übergeben werden und durch Zurückschieben des Trägers 8 mit den beiden Teiltransporten in die Transportstrecke überführt werden. In umgekehrter Reihenfolge kann ein solcher Bauelementeträger aus der Transportstrecke 5 der Förderstrecke 6 übergeben werden, wie dies am rechten Ende der Transportstrecke 5 angedeutet ist. Derartige Verschiebevorgänge sind bei allen Teiltransporten möglich, so daß die Baugruppenträger an beliebiger Stelle in die Transportstecker eingefügt bzw. an die Förderstrecke zurückgegeben werden können.

Die in Figur 1 dargestellten Bewegungspfeile zeigen die entsprechenden Verschiebe-, Antriebs- und Transportrichtungen. Die verschiedenen Bauelementeträger 1 werden hier bereits am Anfang der Transportstrecke übergeben und durchlaufen die einzelnen Bestückplätze auf direktem Wege, so daß entsprechende Wechselvorgänge entfallen.

Bei der in Figur 2 dargestellten Betriebsart werden die Bauelementeträger 1 nicht in Linie, sondern parallel verarbeitet. Dabei werden die Bauelementeträger 1 an nur jeweils einem Bestückplatz 4 komplett bestückt und jeweils vor dem Bestückplatz 4 in die Transportstrecke 5 eingeschleust und unmittelbar danach wieder in die Förderstrecke 6 zurückgeführt. Diese Betriebsweise eignet sich insbesondere für Bauelementeträger (1), die mit einer geringen Anzahl von Bauelementen bestückt werden müssen.

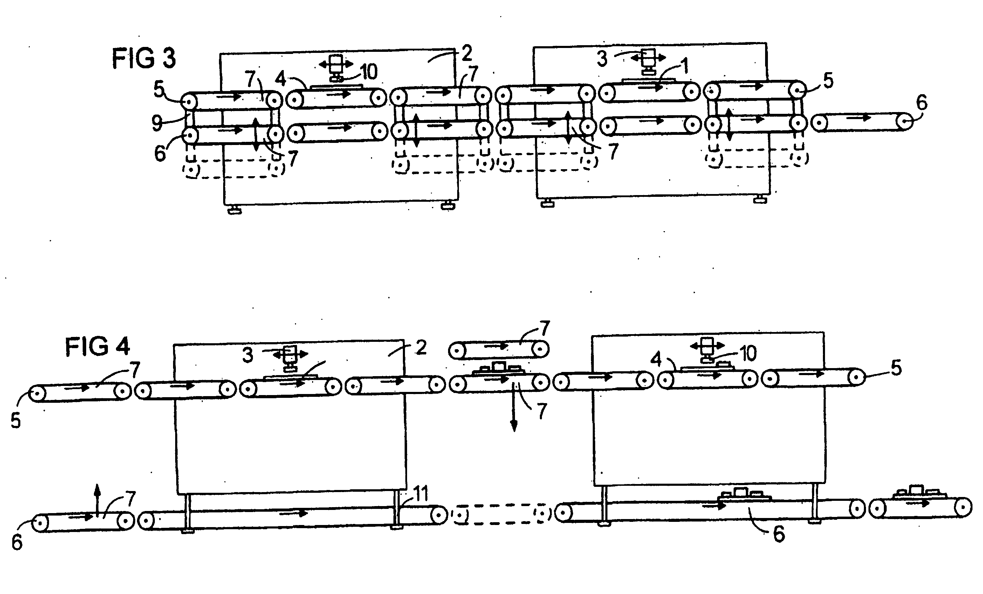

Nach Figur 3 ist die Transportstrecke 5 über der Förderstrecke 6 angeordnet. Ein anderer Träger 9 für jeweils zwei der Teiltransporte 7 ist demgemäß in senkrechter Richtung um den Abstand zwischen den beiden Strecken verschiebbar. Dadurch sind die Bauelementeträger 1 ähnlich wie bei der Anlage nach Figur 1 und 2 wechselweise zwischen den beiden Strecken umsetzbar. Der freie Abstand zwischen den beiden Strecken ist hier der maximalen Höhe des bestückten Baugruppenträgers 1 angenähert, so daß die Verschiebewege entsprechend kurz sind. Bei dieser Anordnung befindet sich der Bestückplatz 4 auf der Oberseite der Strecken, so daß der Bestückkopf 3 die Bauelemente 10 ungehindert und gut zugänglich auf den Bauelementeträger 1 aufsetzen kann.

Nach Figur 4 verläuft die Förderstrecke 6 unterhalb der Bestückautomaten 2, deren Fußteile 11 entsprechend erhöht worden sind. Dies hat den Vorteil, daß die Bestückautomaten 2 unverändert bleiben können. Zwischen jeweils zwei aufeinander folgenden Bestückautomaten sind zwei zusätzliche, in ihrer Höhenlage verschiebbare Teiltransporte 7 angeordnet und in einer nicht näher dargestellten Baueinheit zusammengefaßt. Im Normalfall fluchten sie mit der Transportstrecke 5 bzw. der Förderstrecke 6, wie dies auf der linken Seite der Anlage dargestellt ist.

Der untere Teiltransport 7 ist dabei zwischen der Förderstrecke 6 und der Transportstrecke 5 verschiebbar und kann somit Bauelementeträger 1 zwischen diesen Strecken wechseln. Der obere Teiltransport 7 wird nur soweit nach oben ausgelenkt, daß genügend Platz für die darunter befindlichen bestückten Bauelementeträger 1 verbleibt. Diese beiden Teiltransporte 7 sind somit unabhängig von einander verschiebbar.

## Patentansprüche

1. Anlage zum Bestücken von Bauelementeträgern (1) mit elektrischen Bauelementen in einer Anlage,
wobei die Anlage in einer Montagelinie eine Vielzahl von aneinandergereihten Bestückplätzen für die Bauelementeträger aufweist,
wobei über sämtliche Bestückplätze zumindest eine Transportstrecke (5) für die Bauelementeträger (1) geführt ist
wobei zumindest eine zu dieser im Wesentlichen parallel verlaufende, an den Bestückplätzen vörbeigeführte lineare Förderstrecke (6) zum Transport der Baueleinenteträger (1) vorgesehen ist,
wobei die Montagelinie Ubergabeeinrichtungen (z.B. 7, 8, 9) zum Quertransport der Bauelementeträger (1) zwischen der Transportstrecke (5) und der Förderstrecke (7) aufweist,
wobei zumindest eine der Übergabeeeinrichtungen (z.B. 7, 8, 9) in der Transportrichtung gesehen zwischen zwei aufeinanderfolgenden Bestückplätzen (4) angeordnet sind,
**dadurch gekennzeichnet,**
**daß** in einer Einstellung jeder der Bauelementeträger auf der Transportstrecke in direkter Verkettung über sämtliche Bestückplätze führbar ist,
**daß** in einer anderen Einstellung die Montagelinie in zumindest zwei Teilabschnitte unterteilt ist, an deren Enden jeweils eine der Übergabeeinrichtungen angeordnet ist,
**daß** die Bauelementeträger wahlweise in die Transportstrecke eines der beiden Teilabschnitte eingebbar bzw. auf dem entsprechenden Abschnitt der Förderstrecke am Bestückplatz vorbeiführbar sind und
**daß** die Transportstrecke (5) und die Förderstrecke (6) als Lineartransporte ausgebildet sind, die parallel mit Abstand übereinanderliegend angeordnet sind.

2. Anlage nach Anspruch 1,
**dadurch gekennzeichnet,**
**daß** die Förderstrecke (6) oberhalb der Transportstrecke (5), insbesondere oberhalb der Bestückautomaten verläuft.

3. Anlage nach Anspruch 2,
**dadurch gekennzeichnet,**
**daß** die Transportstrecke (5) in der Höhe des Bestückplatzes (4) angeordnet ist, und
**daß** die Förderstrecke (6) unterhalb der Transportstrecke (5) verläuft.

4. Anlage nach einem der Ansprüche 1 bis 3,
**dadurch gekennzeichnet,**
**daß** der Lineartransport in mehrere aufeinanderfolgende, voneinander unabhängig antreibbare Abschnitte unterteilt ist, daß die Übergabeeinrichtung (z.B. 7,8,9) einem der Abschnitte zugeordnet ist, und
**daß** dieser als Teiltransport (7) ausgebildet ist, der zwischen den beiden Strecken verschiebbar ist.

5. Anlage nach Anspruch 4,
**dadurch gekennzeichnet,**
**daß** die Übergabeeinrichtung aus zwei Teiltransporten (7) gebildet ist, die zumindest temporär mit den Strecken fluchten.

6. Anlage nach Anspruch 5,
**dadurch gekennzeichnet,**
**daß** die beiden Teiltransporte (7) unabhängig von einander verschiebbar sind.

7. Anlage nach Anspruch 6,
**dadurch gekennzeichnet,**
**daß** die beiden Teiltransporte (7) einen zueinander festen Abstand aufweisen und auf einem gemeinsamen, quer zu den Strecken verschiebbaren Träger (8, 9) gehalten sind.

8. Anlage nach einem der vorhergehenden Ansprüche,
**dadurch gekennzeichnet,**
**daß** die Bestückplätze (4) in separaten Bestückautomaten (2) der Anlage angeordnet sind, und
**daß** die Übergabeeinrichtung (z.B. 7, 8, 9) dem Bestückautomaten (2) zugeordnet ist.

9. Anlage nach Anspruch 8,
**dadurch gekennzeichnet,**
**daß** der Bestückautomat (2) vor und nach dem Bestückplatz (4) je eine der Übergabeeinrichtungen (z.B. 7,8,9) aufweist.

10. Anlage nach Anspruch 9,
**dadurch gekennzeichnet,**
**daß** die Übergabeeinrichtung als separate Baueinheit ausgebildet ist, die zwischen den beiden Bestückautomaten (2) angeordnet ist.

11. Anlage nach einem der vorhergehenden Ansprüche,
**dadurch gekennzeichnet,**
**daß** die Förderstrecke in zwei zueinander parallel verlaufende Parallelstrecken unterteilt, ist von denen eine noch unbestückte oder unvollständig bestückte Bauelementeträger und
die andere die bereits bestückten Baüelementeträger führt und daß die Übergabeeeinrichtung neben der senkrechten Richtung zur wahlweisen Ansteuerung beider Paralleltransporte auch waagerecht verschiebbar ist.

12. Anlage nach einem der vorhergehenden Ansprüche,
**dadurch gekennzeichnet,**
**daß** der Teiltransport (7) quer zur Transportrichtung verschiebbar ist,
**daß** parallel neben diesem Teiltransport (7) ein weiterer in der gleichen Richtung verschiebbarer Teiltransport (7) angeordnet ist, und
**daß** die beiden von einander unabhängig antreibbaren Teiltransporte (7) abwechselnd fluchtend auf den angrenzenden Abschnitt der Transportstrecke (5) ausrichtbar sind.

13. Anlage nach Anspruch 12,
**dadurch gekennzeichnet,**
**daß** die beiden Teiltransporte an einem gemeinsamen Träger (8, 9) gehalten sind, der um den Abstand der beiden Teiltransporte (7) quer zur Transportrichtung verschiebbar ist.

14. Anlage nach einem der Ansprüche 3 bis 13,
**dadurch gekennzeichnet,**
**daß** die Förderstrecke (6) unterhalb eines Chassis des Bestückautomaten (2) verläuft, und
**daß** das Chassis zumindest im Bereich der Förderstrecke (6) eine Bodenfreiheit aufweist, die der Höhe des Lineartransportes plus der bestückten Bauelementeträger (1) entspricht.

15. Anlage nach Anspruch 14,
**dadurch gekennzeichnet,**
**daß** Fußteile (11) des Chassis höher sind als der Lineartransport mit dem bestückten Bauelementeträger.

16. Anlage nach einem der Ansprüche 3 bis 13,
**dadurch gekennzeichnet,**
**daß** die Förderstrecke (6) mit geringem Abstand unterhalb des Lineartransportes der Transportstrecke (5) verläuft und
**daß** ein Chassis des Bestückautomaten Aufnahme- und Befestigungsmittel zur optionalen Aufnahme der Transportstrecke aufweist.

## Claims

1. Facility for fitting component carriers (1) with electrical components in a facility,
whereby the facility has numerous stations, following one after another, in an assembly line for inserting components into the component carriers,
whereby at least one transport lane (5) for the component carriers (1) leads past all the insertion stations
whereby at least one linear conveyor lane (6) is provided for transporting the component carriers (1), running essentially parallel to the transport lane, and bypassing the insertion stations,
whereby the assembly line has transfer devices (e.g. 7, 8, 9) for transporting the component carriers (1) transversely between the transport lane (5) and the conveyor lane (7),
whereby, when looking in the direction of transport, at least one of the transfer devices (e.g. 7, 8, 9) is arranged between two consecutive insertion stations (4),
**characterized in that**
in one of its settings, each of the component carriers can be transported on the transport lane past all the insertion stations in a direct chain,
in another setting the assembly line is subdivided into at least two sub-sections at each end of which is arranged one of the transfer devices,
the component carriers can be arbitrarily fed onto the transport lane for one of these two sub-sections, or can be transported past the insertion station on the corresponding section of the conveyor lane, as appropriate, and
that the transport lane (5) and the conveyor lane (6) take the form of linear transport mechanisms, positioned a certain distance apart one above the other and parallel to each other.

2. Facility in accordance with claim 1,
**characterized in that**
the conveyor lane (6) runs above the transport lane (5), in particular above the component insertion machines.

3. Facility in accordance with claim 2,
**characterized in that**
the transport lane (5) is arranged at the height of the insertion station (4), and
the conveyor lane (6) runs underneath the transport lane (5).

4. Facility in accordance with one of the claims 1 to 3,
**characterized in that**
the linear transport is subdivided into several sections, one after another, which can be driven independently,
the transfer device (e.g. 7,8,9) is assigned to one of the sections, and
that this takes the form of a transport unit (7) which can be inserted between the two lanes.

5. Facility in accordance with claim 4,
**characterized in that**
the transfer device is made up of two transport units (7) which, at least temporarily, can be aligned along the lanes

6. Facility in accordance with claim 5,
**characterized in that**
the two transport units (7) can be displaced independently of one another.

7. Facility in accordance with claim 6,
**characterized in that**
the two transport units (7) have a fixed distance between them and are held on a common carrier (8, 9) which can be moved across the lanes.

8. Facility in accordance with one of the preceding claims,
**characterized in that**
the insertion stations (4) are arranged in separate component insertion machines (2) within the facility, and
that the transfer device (e.g. 7, 8, 9) is assigned to the component insertion machine (2).

9. Facility in accordance with claim 8,
**characterized in that**
the component insertion machine (2) has one transfer device (e.g. 7,8,9) before and one after the insertion station (4).

10. Facility in accordance with claim 9,
**characterized in that**
the transfer device takes the form of a separate assembly, which is arranged between the two component insertion machines (2).

11. Facility in accordance with one of the preceding claims,
**characterized in that**
the conveyor lane is subdivided into two lanes parallel to one another, of which one transports component carriers which have not yet had any, or not all, of their components inserted, and the other transports the component carriers which already have all their components inserted, and
that the transfer device can not only be moved in a vertical direction, so that either parallel transport can be selected arbitrarily, but also horizontally.

12. Facility in accordance with one of the preceding claims,
**characterized in that**
the transport unit (7) can be moved across the direction of transport,
arranged in parallel beside this transport unit (7) is a further transport unit (7) which can be moved in the same direction, and that these two transport units (7), which can be driven independently of each other, can be alternately aligned in line with the adjacent sections of the transport lane (5).

13. Facility in accordance with claim 12,
**characterized in that**
the two transport units are held on a common carrier (8, 9), which can be moved across the direction of transport by a distance equal to the space between the two transport units (7).

14. Facility in accordance with one of the claims 3 to 13,
**characterized in that**
the conveyor lane (6) runs underneath the frame of the component insertion machine (2), and
that this frame has a ground clearance, at least in the region of the conveyor lane (6), which corresponds to the height of the linear transport plus the component carriers (1) with components inserted.

15. Facility in accordance with claim 14,
**characterized in that**
the footpieces (11) of the frame are higher than the linear transport plus the component carriers with components inserted.

16. Facility in accordance with one of the claims 3 to 13,
**characterized in that**
the conveyor lane (6) runs underneath the linear transport for the transport lane (5) with a small clearance, and
that a frame on the component insertion machine has a means of accommodating and affixing the optional fitment of the transport lane.

## Revendications

1. Installation destinée à équiper des supports de composants (1) avec des composants électriques au sein d'une installation,
l'installation présentant dans une ligne de montage une pluralité de postes de montage alignés pour les supports de composants,
au moins une chaîne de transport (5) pour les supports de composants (1) s'étendant au-dessus de l'ensemble des postes de montage,
au moins une chaîne d'alimentation linéaire (6) qui s'étend sensiblement en parallèle à cette dernière et passe à l'avant des postes de montage étant prévue pour le transport des supports de composants (1),
la ligne de montage présentant des systèmes de transfert (par exemple 7, 8, 9) pour le transport transversal des supports de composants (1) entre la chaîne de transport (5) et la chaîne d'alimentation (7),
au moins l'un des systèmes de transfert (par exemple 7, 8, 9) étant disposé entre deux postes de montage (4) consécutifs, vus dans le sens du transport,
**caractérisée en ce que**, selon un mode de réglage, chacun des supports de composants peut être conduit sur la chaîne de transport par enchaînement direct au-dessus de l'ensemble des postes de montage,
**en ce que** selon un autre mode de réglage, la ligne de montage est divisée en au moins deux sections partielles, aux extrémités desquelles l'un des systèmes de transfert est respectivement disposé,
**en ce que** les supports de composants peuvent être introduits au choix dans la chaîne de transport de l'une des deux sections partielles ou être conduites à l'avant du poste de montage, sur la section correspondante de la chaîne d'alimentation, et
**en ce que** la chaîne de transport (5) et la chaîne d'alimentation (6) sont conçues en tant que transports linéaires, disposés en parallèle à une certaine distance l'un au-dessus de l'autre.

2. Installation selon la revendication 1, **caractérisée en ce que** la chaîne d'alimentation (6) s'étend au-dessus de la chaîne de transport (5), notamment au-dessus des robots de montage.

3. Installation selon la revendication 2, **caractérisée en ce que** la chaîne de transport (5) est disposée dans le haut du poste de montage (4) et **en ce que** la chaîne d'alimentation (6) s'étend en dessous de la chaîne de transport (5).

4. Installation selon l'une quelconque des revendications 1 à 3, **caractérisée en ce que** le transport linéaire est divisé en plusieurs tronçons consécutifs, pouvant être entraînés indépendamment l'un de l'autre,
**en ce que** le système de transfert (par exemple 7, 8, 9) est associé à l'un des tronçons, et
**en ce que** ce dernier est conçu en tant que tronçon de transport (7), pouvant être déplacé entre les deux chaînes.

5. Installation selon la revendication 4, **caractérisée en ce que** le système de transfert est formé par deux tronçons de transport (7), qui sont au moins temporairement alignés sur les chaînes.

6. Installation selon la revendication 5, **caractérisée en ce que** les deux tronçons de transport (7) sont déplaçables indépendamment l'un de l'autre.

7. Installation selon la revendication 6, **caractérisée en ce que** les deux tronçons de transport (7) sont placés à une distance fixe l'une de l'autre et sont maintenus sur un support (8, 9) commun, qui est déplaçable transversalement aux chaînes.

8. Installation selon l'une quelconque des revendications précédentes,
**caractérisée en ce que** les postes de montage (4) sont disposés dans des robots de montage (2) séparés de l'installation, et
**en ce que** le système de transfert (par exemple 7, 8, 9) est associé au robot de montage (2).

9. Installation selon la revendication 8, **caractérisée en ce que** le robot de montage (2) présente en amont et en aval du poste de montage (4) respectivement l'un des systèmes de transfert (par exemple 7, 8, 9).

10. Installation selon la revendication 9, **caractérisée en ce que** le système de transfert est conçu sous forme d'unité séparée, laquelle est disposée entre les deux robots de montage (2).

11. Installation selon l'une quelconque des revendications précédentes, **caractérisée en ce que** la chaîne d'alimentation est divisée en deux chaînes parallèles disposées en parallèle l'une par rapport à l'autre, dont l'une transporte des supports de composants non encore équipés ou incomplètement équipés et dont l'autre transporte les supports de composants d'ores et déjà équipés et **en ce que**, hormis sa direction verticale, le système de transfert est également déplaçable à l'horizontale, pour activer l'un quelconque des deux transports parallèles.

12. Installation selon l'une quelconque des revendications précédentes, **caractérisée en ce que** le tronçon de transport (7) est déplaçable transversalement au sens de transport, **en ce qu'**un autre tronçon de transport (7), déplaçable dans la même direction est disposé parallèlement à ce tronçon de transport (7) et **en ce que** les deux tronçons de transport qui peuvent être entraînés indépendamment l'un de l'autre sont alternativement orientables dans l'alignement de la section limitrophe de la chaîne de transport (5).

13. Installation selon la revendication 12, **caractérisée en ce que** les deux tronçons de transport sont maintenus sur un support commun (8, 9), lequel est déplaçable de la valeur de la distance entre les deux tronçons de transport (7), transversalement au sens de transport.

14. Installation selon l'une quelconque des revendications 3 à 13, **caractérisée en ce que** la chaîne d'alimentation (6) s'étend en dessous d'un châssis du robot de montage (2) et **en ce que** le châssis présente au moins dans la région de la chaîne d'alimentation (6) une hauteur au-dessus du sol correspondant à la hauteur du transport linéaire à laquelle on rajoute la hauteur des supports de composants équipés (1).

15. Installation selon la revendication 14, **caractérisée en ce que** des pieds (11) du châssis sont plus hauts que le transport linéaire avec les supports de composants équipés.

16. Installation selon l'une quelconque des revendications 3 à 13, **caractérisée en ce que** la chaîne d'alimentation (6) s'étend à faible distance sous le transport linéaire de la chaîne de transport (5) et **en ce qu'**un châssis du robot de montage présente des moyens de réception et de fixation, destinés à réceptionner en option la chaîne de transport.
